# EUROPEAN PATENT APPLICATION

(11) **EP 1 936 702 A1**
(43) Date of publication of application: **25.06.2008**
(21) Application number: 06768287.2
(22) Date of filing: 19.07.2006
(51) Int. Cl.: H01L 31/068, H01L 31/18

(54) **METHOD OF MANUFACTURING BACK JUNCTION SOLAR CELL**

(30) Priority: 22.09.2005 JP 2005275927
(71) Applicant: Sharp Kabushiki Kaisha, Osaka-shi, Osaka 545-8522 (JP)
(72) Inventor: FUNAKOSHI, Yasushi, Uda-shi, Nara 633-0257 (JP)
(74) Representative: Müller - Hoffmann & Partner
(86) International application number: PCT/JP2006/314261
(87) International publication number: WO 2007/034614

(57) **Abstract**

A method of manufacturing a back junction solar cell comprises the steps of forming a first diffusion mask (9) on the back of a silicon substrate (1), printing a first etching paste (3a, 4a) on a part of the surface of the first diffusion mask (9), removing the portion of the first diffusion mask (9) where the first etching paste (3 a, 4a) is printed by performing a first heating of the silicon substrate (1) to expose a part of the back of the silicon substrate (1), forming a first-conductivity-type impurity diffusion layer (6) on the exposed portion of the silicon substrate (1) by diffusing a first-conductivity-type impurity, removing the first diffusion mask (9), forming a second diffusion mask (9) on the back of the silicon substrate (1), printing a second etching paste (3b, 4b) on a part of the surface of the second diffusion mask (9), removing the portion of the second diffusion mask (9) where the second etching paste (3b, 4b) is printed by performing a second heating of the silicon substrate (1) to expose a part of the back of the silicon substrate (1), forming a second-conductivity-type impurity diffusion layer (5) on the exposed portion of the silicon substrate (1) by diffusing a second-conductivity-type impurity, and removing the second diffusion mask (9).

## Description

### TECHNICAL FIELD

The present invention relates to a method of manufacturing a back junction solar cell, and more particularly, it relates to a method of manufacturing a back junction solar cell capable of reducing the manufacturing cost by substituting printing steps for photolithographic steps.

### BACKGROUND ART

Development of clean energy has recently been desired in view of the problem of exhaustion of energy resources and the global environment problem such as increase of CO₂ in the air, and photovoltaic power generation employing a solar cell has been developed and put into practice as a new energy source, and is now on the way to progress.

A solar cell manufactured by diffusing an impurity of a conductivity type reverse to the conductivity type of a single-crystalline or polycrystalline silicon substrate into a photo-receiving surface of the silicon substrate thereby forming a p-n junction and forming electrodes on the photo-receiving surface of the silicon substrate and the back surface opposite thereto respectively forms the mainstream in general. An impurity of the same conductivity type as the silicon substrate is generally diffused into the back surface of the silicon substrate in a high concentration, in order to increase the output due to a back surface field effect.

Further, the so-called back junction solar cell manufactured by forming a p-n junction on the back surface of a silicon substrate without forming an electrode on the photo-receiving surface of the silicon substrate is developed. The back junction solar cell, generally having no electrode on the photo-receiving surface, has no shadow loss resulting from an electrode, and can expectedly obtain a higher output as compared with the aforementioned solar cell having the electrodes on the photo-receiving surface and the back surface of the silicon substrate respectively. The back junction solar cell is applied to a solar car or a concentrating solar cell through such properties.

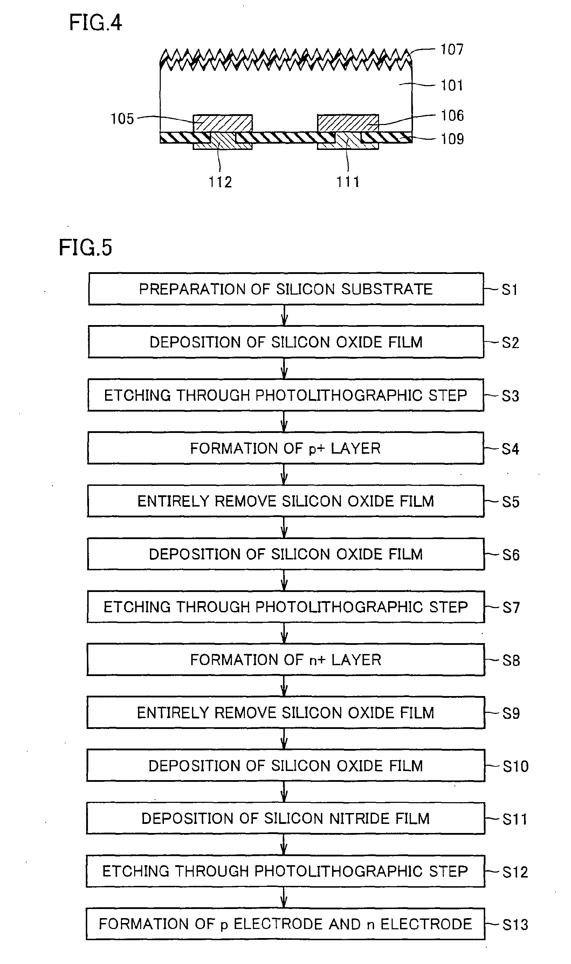

Fig. 4 is a schematic sectional view of an exemplary back junction solar cell. In the back junction solar cell, an antireflection film 107 is formed on a photo-receiving surface of an n-type silicon substrate 101 etched into a textured structure, for example, and a silicon oxide film 109 is formed on the back surface of silicon substrate 101. An n⁺ layer 105 and a p⁺ layer 106 are alternately formed on the back surface of silicon substrate 101 at a prescribed interval along the back surface, and a p electrode 111 is formed on p⁺ layer 106, while an n electrode 112 is formed on n⁺ layer 105. When sunlight is incident upon the photo-receiving surface of this back junction solar cell, generated carriers reach a p-n junction (interface between n-type silicon substrate 101 and p⁺ layer 106) and thereafter separated by the p-n junction, collected by p electrode 111 and n electrode 112, and extracted from the cell as a current to form the output of the back junction solar cell.

Fig. 5 is a flow chart showing exemplary steps of manufacturing this back junction solar cell. First, an n-type silicon substrate having a photo-receiving surface etched into a textured structure is prepared at a step 1 (S1). At a step 2 (S2), silicon oxide films serving as first diffusion masks are deposited on the photo-receiving surface and the back surface of this silicon substrate by APCVD (atmospheric pressure CVD).

At a step 3 (S3), the silicon oxide film formed on the back surface of this silicon substrate is partially removed by etching through a photolithographic step. Thereafter a p⁺ layer is formed on the back surface of the silicon substrate by diffusing boron employed as a p-type impurity by vapor phase diffusion employing BBr₃ at a step 4 (S4). Then, the silicon oxide films are entirely removed from the photo-receiving surface and the back surface of the silicon substrate at a step 5 (S5). Then, silicon oxide films are deposited on the overall surfaces of the photo-receiving surface and the back surface of the silicon substrate again at a step 6(S6).

Then, the silicon oxide film formed on the back surface of the silicon substrate is partially removed to face the p⁺ layer by performing etching through a photolithographic step at a step 7 (S7). Thereafter an n⁺ layer is formed on the back surface of the silicon substrate by diffusing phosphorus employed as an n-type impurity by vapor phase diffusion employing POCl₃ at a step 8 (S8). Then, the silicon oxide films are entirely removed from the photo-receiving surface and the back surface of the silicon substrate at a step 9 (S9). Then, silicon oxide films are deposited on the overall surfaces of the photo-receiving surface and the back surface of the silicon substrate again at a step 10 (S10).

Thereafter the silicon oxide film formed on the photo-receiving surface of the silicon substrate is removed at a step 11 (S11), and a silicon nitride film is thereafter deposited as an antireflection film by plasma CVD. At a step 12 (S12), the silicon oxide film formed on the back surface of the silicon substrate is partially removed by etching through a photolithographic step, for exposing the p⁺ layer and the n⁺ layer from the removed portion respectively.

Finally, a p electrode and an n electrode are formed on the p⁺ layer and the n⁺ layer respectively by performing vapor deposition on the regions of the p⁺ layer and the n⁺ layer exposed on the back surface of the silicon substrate by etching through a photolithographic step at a step 13 (S13). Thus, the back junction solar cell is completed.
Patent Document 1: National Patent Publication Gazette No. 2003-531807
Patent Document 2: National Patent Publication Gazette No. 2004-520713

### DISCLOSURE OF THE INVENTION

### PROBLEMS TO BE SOLVED BY THE INVENTION

In the conventional method of manufacturing a back junction solar cell, however, the manufacturing cost is disadvantageously increased due to the large number of photolithographic steps as described above.

An object of the present invention is to provide a method of manufacturing a back junction solar cell capable of reducing the manufacturing cost by substituting printing steps for photolithographic steps.

### MEANS FOR SOLVING THE PROBLEMS

The present invention provides a method of manufacturing a back junction solar cell having a p-n junction formed on the back surface of a first conductivity type or second conductivity type silicon substrate opposite to the surface of the incident light side, comprising the steps of forming a first diffusion mask on the back surface of the silicon substrate, printing a first etching paste containing an etching component capable of etching the first diffusion mask on a part of the surface of the first diffusion mask, exposing a part of the back surface of the silicon substrate by performing a first heat treatment on the silicon substrate thereby removing the part of the first diffusion mask printed with the first etching paste, forming a first conductivity type impurity diffusion layer on the exposed back surface of the silicon substrate by diffusing a first conductivity type impurity, removing the first diffusion mask, forming a second diffusion mask on the back surface of the silicon substrate, printing a second etching paste containing an etching component capable of etching the second diffusion mask on a part of the surface of the second diffusion mask, exposing another part of the back surface of the silicon substrate by performing a second heat treatment on the silicon substrate thereby removing the part of the second diffusion mask printed with the second etching paste, forming a second conductivity type impurity diffusion layer on the exposed back surface of the silicon substrate by diffusing a second conductivity type impurity, and removing the second diffusion mask.

According to a first aspect of the method of manufacturing a back junction solar cell according to the present invention, the etching component of at least either the first etching paste or the second etching paste can be phosphoric acid.

In the first aspect of the method of manufacturing a back junction solar cell according to the present invention, the etching component is preferably contained by at least 10 mass % and not more than 40 mass % with respect to the mass of the overall etching paste.

In the first aspect of the method of manufacturing a back junction solar cell according to the present invention, the viscosity of the etching paste containing the etching component is preferably set to at least 10 Pa·s and not more than 40 Pa.s.

In the first aspect of the method of manufacturing a back junction solar cell according to the present invention, the heating temperature for at least either the first heat treatment or the second heat treatment is preferably at least 200°C and not more than 400°C.

In the first aspect of the method of manufacturing a back junction solar cell according to the present invention, the treatment time for at least either the first heat treatment or the second heat treatment is preferably at least 30 seconds and not more than 180 seconds.

According to a second aspect of the method of manufacturing a back junction solar cell according to the present invention, the etching component of at least either the first etching paste or the second etching paste can be at least one component selected from a group consisting of hydrogen fluoride, ammonium fluoride and ammonium hydrogen fluoride.

In the second aspect of the method of manufacturing a back junction solar cell according to the present invention, the etching component is preferably contained by at least 5 mass % and not more than 20 mass % with respect to the mass of the overall etching paste.

In the second aspect of the method of manufacturing a back junction solar cell according to the present invention, the viscosity of the etching paste containing the etching component is preferably at least 10 Pa·s and not more than 25 Pa.s.

In the second aspect of the method of manufacturing a back junction solar cell according to the present invention, the heating temperature for at least either the first heat treatment or the second heat treatment is preferably at least 50°C and not more than 200°C.

In the second aspect of the method of manufacturing a back junction solar cell according to the present invention, the treatment time for at least either the first heat treatment or the second heat treatment is preferably at least 10 seconds and not more than 120 seconds.

In the method of manufacturing a back junction solar cell according to the present invention, the first conductivity type impurity diffusion layer and the second conductivity type impurity diffusion layer are preferably not in contact with each other, but an interval of at least 10 µm and not more than 200 µm is preferably provided between the first conductivity type impurity diffusion layer and the second conductivity type impurity diffusion layer.

In the method of manufacturing a back junction solar cell according to the present invention, at least either the first etching paste subjected to the first heat treatment or the second etching paste subjected to the second heat treatment can be removed by ultrasonic cleaning and flowing water cleaning.

In the method of manufacturing a back junction solar cell according to the present invention, at least either the first diffusion mask or the second diffusion mask may be formed by at least either a silicon oxide film or a silicon nitride film.

The method of manufacturing a back junction solar cell according to the present invention can include the steps of forming a passivation film on the back surface of the silicon substrate, printing a third etching paste containing an etching component capable of etching the passivation film on a part of the surface of the passivation film, and exposing at least a part of the first conductivity type impurity diffusion layer and at least a part of the second conductivity type impurity diffusion layer by performing a third heat treatment on the silicon substrate thereby removing the part of the passivation film printed with the third etching paste, after removing the second diffusion mask.

In the method of manufacturing a back junction solar cell according to the present invention, the etching component of the third etching paste can be at least one component selected from a group consisting of hydrogen fluoride, ammonium fluoride and ammonium hydrogen fluoride or phosphoric acid.

The method of manufacturing a back junction solar cell according to the present invention may include the step of forming a first electrode in contact with the exposed surface of the first conductivity type diffusion layer and a second electrode in contact with the exposed surface of the second conductivity type impurity diffusion layer respectively.

In the present invention, "incident light side surface" indicates the surface of the silicon substrate generally directed to the side upon which sunlight is incident when the silicon substrate is employed as the solar cell. In this specification, the "incident light side surface" may also be referred to as "photo-receiving surface".

In the present invention, "first conductivity type" denotes the conductivity type of either the n type or the p type, and "second conductivity type" denotes the conductivity type, either the n type or the p type, different from the first conductivity type.

### EFFECTS OF THE INVENTION

According to the present invention, a method of manufacturing a back junction solar cell capable of reducing the manufacturing cost by substituting printing steps for photolithographic steps can be obtained.

### BRIEF DESCRIPTION OF THE DRAWINGS

Fig. 1(a) is a schematic plan view of the back surface of a back junction solar cell obtained by the method of manufacturing a back junction solar cell according to the present invention, and 1(b) is a schematic sectional view taken along the line IB-IB in Fig. 1(a).
Fig. 2 is schematic sectional views showing exemplary manufacturing steps in the method of manufacturing a back junction solar cell according to the present invention capable of obtaining the back junction solar cell shown in Figs. 1(a) and 1(b).
Fig. 3 is sectional views showing other exemplary manufacturing steps in the method of manufacturing a back junction solar cell according to the present invention capable of obtaining the back junction solar cell shown in Figs. 1(a) and 1(b).
Fig. 4 is a schematic sectional view of an exemplary conventional back junction solar cell.
Fig. 5 is a flow chart showing exemplary steps of manufacturing the back junction solar cell shown in Fig. 4.

### DESCRIPTION OF THE REFERENCE SIGNS

1,101 silicon substrate, 2 alignment mark, 3a, 4a first etching paste, 3b, 4b second etching paste, 5, 105 n⁺ layer, 6, 106 p⁺ layer, 7, 107 antireflection film, 9, 109 silicon oxide film, 11, 111 p electrode, 12, 112 n electrode.

### BEST MODES FOR CARRYING OUT THE INVENTION

### (First Embodiment)

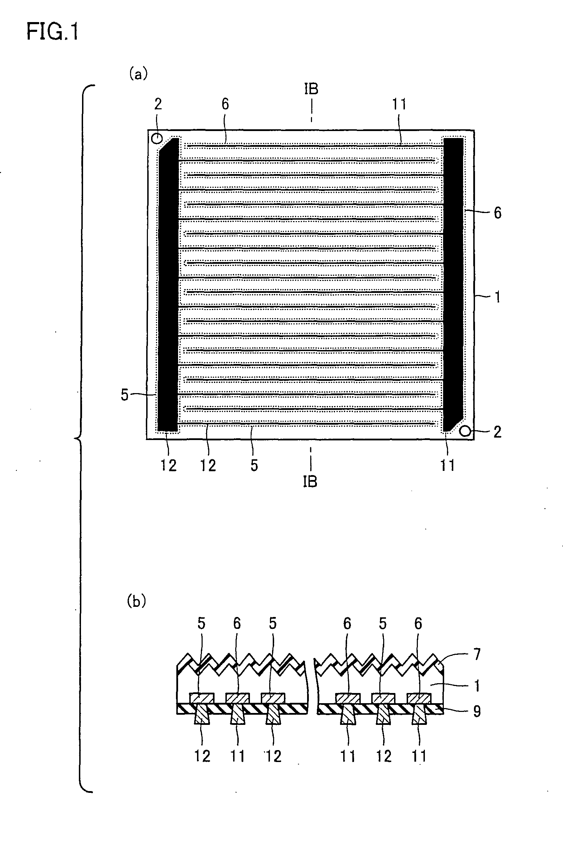

Fig. 1(a) is a schematic plan view showing the back surface of a back junction solar cell obtained by the method of manufacturing a back junction solar cell according to the present invention. An n⁺ layer 5 serving as a second conductivity type impurity diffusion layer in which an n-type impurity employed as a second conductivity type impurity is diffused and a p⁺ layer 6 serving as a first conductivity type impurity layer in which a p-type impurity employed as a first conductivity type impurity is diffused are arranged on ends of the back surface of a silicon substrate 1 of the n-type which is a second conductivity type at an interval to be parallel to each other in the form of single thick strips respectively, while a plurality of thin strip-shaped n⁺ layers and a plurality of thin strip-shaped p⁺ layers extend from strip-shaped n⁺ layer 5 and p⁺ layer 6 toward the inner side of the back surface of silicon substrate 1 respectively. Thin strip-shaped n⁺ layers and p⁺ layers extending toward the inner side of the back surface of silicon substrate 1 are alternately arranged respectively. N electrodes 12 serving as second electrodes are formed on n⁺ layers 5, and p electrodes 11 serving as first electrodes are formed on p⁺ layers 6. A p-n junction is formed by n-type silicon substrate 1 and p⁺ layers 6.

Fig. 1(b) is a schematic sectional view taken along the line IB-IB in Fig. 1(a). The photo-receiving surface of silicon substrate 1 is etched to form a textured structure, an antireflection film 7 is formed on the photo-receiving surface, and a silicon oxide film 9 serving as a passivation film is formed on the back surface of silicon substrate 1. N⁺ layers 5 and p⁺ layers 6 are alternately formed along the back surface of silicon substrate 1 at prescribed intervals respectively. A p-n junction is formed on the back surface of silicon substrate 1 by n-type silicon substrate 1 and p⁺ layers 6. P electrodes 11 are formed on p⁺ layers 6, and n electrodes 12 are formed on n⁺ layers 5.

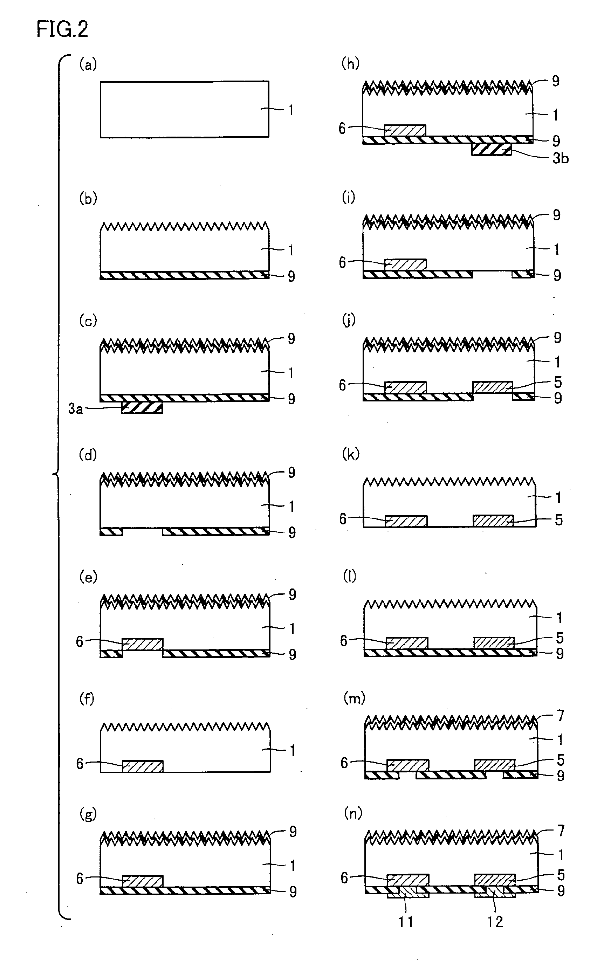

Figs. 2(a) to (n) are schematic sectional views showing exemplary manufacturing steps in the method of manufacturing a back junction solar cell according to the present invention capable of obtaining the back junction solar cell shown in Figs. 1(a) and 1(b). While only one n⁺ layer and only one p⁺ layer are formed on the back surface of the silicon substrate in each of Figs. 2(a) to (n) for convenience of illustration, a plurality of n⁺ layers and a plurality of p⁺ layers are formed in practice.

First, n-type silicon substrate 1 is prepared, as shown in Fig. 2(a). Polycrystalline silicon or single-crystalline silicon, for example, can be employed as silicon substrate 1. Silicon substrate 1 may be of the p type, and a p-n junction is formed on the back surface by the n⁺ layer provided on the back surface of silicon substrate 1 and p-type silicon substrate 1 when silicon substrate 1 is of the p-type. Silicon substrate 1, not particularly restricted in size and shape, can be in the form of a tetragon having a thickness of at least 100 µm and not more than 300 µm with each side of at least 100 mm and not more than 150 mm, for example. In order to improve printing accuracy of etching pastes, two circular alignment marks 2 are formed on the back surface of silicon substrate 1 with a laser marker, as shown in Fig. 1(a). Alignment marks 2 are preferably set on portions other than the portions for forming n⁺ layer 5 and p⁺ layer 6, in order not to deteriorate the performance of the back junction solar cell.

For example, a substrate from which slice damages resulting from slicing are removed or the like is employed as silicon substrate 1 shown in Fig. 2(a). The slice damages are removed from silicon substrate 1 by etching the surface of silicon substrate 1 with mixed acid of an aqueous hydrogen fluoride solution and nitric acid or an alkaline solution of sodium hydroxide or the like.

Then, silicon oxide film 9 serving as a textured mask is formed on the back surface of silicon substrate 1, and a textured structure is further formed on the photo-receiving surface of silicon substrate 1, as shown in Fig. 2(b). Thus, the textured structure can be formed only on the photo-receiving surface and the back surface can be rendered planar by forming silicon oxide film 9 on the back surface of silicon substrate 1 as the textured mask. Silicon oxide film 9 can be formed by steam oxidation, atmospheric pressure CVD or printing/baking of SOG (spin on glass), for example. Silicon oxide film 9, not particularly restricted in thickness, can be set to a thickness of at least 300 nm and not more than 800 nm, for example.

As the textured mask, a silicon nitride film or a laminate of a silicon oxide film and a silicon nitride film can be employed in place of the silicon oxide film. The silicon nitride film can be formed by plasma CVD or atmospheric pressure CVD, for example. The silicon nitride film, not particularly restricted in thickness, can be set to a thickness of at least 60 nm and not more than 100 nm, for example.

The silicon oxide film and/or the silicon nitride film forming the textured mask can be utilized as a first diffusion mask in the subsequent impurity diffusing step. The silicon oxide film and/or the silicon nitride film forming the textured mask can also be temporarily removed after formation of the textured structure.

The textured structure of the photo-receiving surface can be formed by performing etching with a material obtained by heating a liquid prepared by adding isopropyl alcohol to an aqueous alkaline solution of sodium hydroxide or potassium hydroxide, for example, to at least 70°C and not more than 80°C, for example.

Then, silicon oxide film 9 provided on the back surface of silicon substrate 1 is temporarily removed with an aqueous hydrogen fluoride solution or the like, and silicon oxide films 9 serving as first diffusion masks are thereafter formed on the respective ones of the photo-receiving surface and the back surface of silicon substrate 1 again, as shown in Fig. 2(c). Then, a first etching paste 3a containing an etching component capable of etching silicon oxide film 9 is printed on a part of silicon oxide film 9 provided on the back surface of silicon substrate 1. First etching paste 3a is printed by screen printing, for example, on the part of silicon oxide film 9 corresponding to the portion for forming the p⁺ layer.

First etching paste 3a contains phosphoric acid as the etching component, and further contains water, an organic solvent and a thickener as components other than the etching component. At least one of alcohol such as ethylene glycol, ether such as ethylene glycol monobutyl ether, ester such as propylene carbonate and ketone such as N-methyl-2-pyrrolidone can be employed as the organic solvent. While an organic solvent other than the above can also be employed, a solvent having a boiling point of about 200°C and hardly causing viscosity change of first etching paste 3a in printing is preferably selected in particular. At least one of cellulose, ethyl cellulose, a cellulose derivative, polyamide resin such as nylon 6 and a polymer such as polyvinyl pyrrolidone prepared by polymerizing a vinyl group can be employed as the thickener.

Phosphoric acid forming the etching component is preferably contained by at least 10 mass % and not more than 40 % with respect to the mass of overall first etching paste 3a. There is such a tendency that sufficient etching performance cannot be obtained if the content of phosphoric acid is less than 10 mass % with respect to the mass of overall first etching paste 3a, and there is a possibility that the viscosity of first etching paste 3a so lowers as to cause a problem in printability if the content of phosphoric acid is larger than 40 mass % with respect to the mass of overall first etching paste 3a.

The viscosity of first etching paste 3a is preferably set to at least 10 Pa·s and not more than 40 Pa·s by properly selecting and adjusting the aforementioned materials, in order to attain compatibility between the etching property and the printability.

Silicon oxide film 9 serving as the first diffusion mask can be formed by steam oxidation, atmospheric pressure CVD or printing/baking of SOG (spin on glass), for example. Silicon oxide film 9, not particularly restricted in thickness, can be set to a thickness of at least 100 nm and not more than 300 nm, for example. As the first diffusion mask, a silicon nitride film or a laminate of a silicon oxide film and a silicon nitride film can be employed in place of the silicon oxide film. The silicon nitride film can be formed by plasma CVD or atmospheric pressure CVD, for example. The silicon nitride film, not particularly restricted in thickness, can be set to a thickness of at least 40 nm and not more than 80 nm, for example.

Then, a first heat treatment is performed on silicon substrate 1 printed with first etching paste 3a, thereby etching and removing the part of silicon oxide film 9, provided on the back surface of silicon substrate 1, printed with first etching paste 3a, as shown in Fig. 2(d). When the first diffusion mask is formed by a silicon oxide film, the heating temperature in the first heat treatment is preferably at least 300°C and not more than 400°C. There is such a tendency that etching is so insufficient that silicon oxide film 9 remains if the first diffusion mask is formed by a silicon oxide film and the heating temperature for first etching paste 3a is less than 300°C, while there is a possibility that first etching paste 3 a is scorched and stuck to the back surface of the silicon substrate and cannot be completely removed if the heating temperature exceeds 400°C. When the first diffusion mask is formed by a silicon nitride film, the heating temperature in the first heat treatment is preferably at least 200°C and not more than 400°C. There is such a tendency that etching is so insufficient that the silicon nitride film remains if the first diffusion mask is formed by a silicon nitride film and the heating temperature for first etching paste 3a is less than 200°C, while there is a possibility that first etching paste 3a is scorched and stuck to the back surface of the silicon substrate and cannot be completely removed if the heating temperature exceeds 400°C.

The treatment time in the first heat treatment is preferably at least 30 seconds and not more than 180 seconds. If the treatment time in the first heat treatment is less than 30 seconds, there is a possibility that a part of silicon oxide film 9 cannot be sufficiently etched even if the heating temperature in the first treatment is set to 400°C. Even when the heating temperature in the first heat treatment is less than 400°C, first etching paste 3a is so denatured that it is difficult to remove the same after the heating when long-time heating is performed, and hence the heating time for the first heat treatment is preferably in the range not exceeding 180 seconds.

As a result of experiments, the etching rate for heating first etching paste 3a printed on a silicon oxide film formed by atmospheric pressure CVD at 300°C was about 150 nm/min., and the etching rate for heating first etching paste 3a printed on a silicon nitride film formed by atmospheric pressure CVD at 300°C was about 240 nm/min.

First etching paste 3a containing phosphoric acid as the etching component hardly reacts at the room temperature and there is such a tendency that phosphoric acid is so hardly vaporized in heating that the part other than the printed part is hardly over-etched, whereby etching at a high aspect ratio close to etching performed through a photolithographic step is enabled. Therefore, a definite pattern can be formed while setting the interval between the n⁺ layer and the p⁺ layer described later to at least 10 µm and not more than 200 µm, preferably at least 10 µm and not more than 100 µm, leading to high efficiency of the back junction solar cell.

The first heat treatment is not particularly restricted in method, but can be performed by heating the substrate on a hot plate, in a belt furnace or in an oven, for example. Phosphoric acid forming the etching component of first etching paste 3a is hardly vaporized as described above, whereby there is little apprehension of corroding the apparatus, and the belt furnace or the oven can be used. In particular, heating in the belt furnace or the oven is preferable in the point that temperature difference is hardly caused between the periphery and the center of silicon substrate 1 and dispersion in etching can be suppressed.

After the first heat treatment, first etching paste 3a subjected to the first heat treatment is removed by dipping silicon substrate 1 in water, performing ultrasonic cleaning by applying ultrasonic waves and thereafter performing flowing water cleaning by feeding flowing water to the back surface of silicon substrate 1. Thus, it follows that the back surface of silicon substrate 1 is partially exposed. The back surface of silicon substrate 1 can also be cleaned by generally known RCA cleaning, cleaning with a mixed solution of sulfuric acid and hydrogen peroxide water or cleaning with a dilute aqueous hydrogen fluoride solution or a detergent containing a surface active agent, in addition to the flowing water cleaning.

Boron which is a p-type impurity employed as a first conductivity type impurity is diffused in the exposed back surface of silicon substrate 1 by vapor phase diffusion employing BBr₃, whereby p⁺ layer 6 is formed as a first conductivity type impurity diffusion layer, as shown in Fig. 2(e). Thereafter silicon oxide films 9 provided on the photo-receiving surface and the back surface of silicon substrate 1 and BSG (borosilicate glass) formed by the diffusion of boron are entirely removed with an aqueous hydrogen fluoride solution or the like, as shown in Fig. 2(f). Alternatively, p⁺ layer 6 may be formed by coating the exposed surface of the back surface of silicon substrate 1 with a solvent containing boron and thereafter heating the same.

Then, silicon oxide films 9 are formed on the overall surfaces of the photo-receiving surface and the back surface of silicon substrate 1 as second diffusion masks, as shown in Fig. 2(g). Needless to say, silicon nitride films or laminates of silicon oxide films and silicon nitride films can be employed as the second diffusion masks, in place of the silicon oxide films.

Then, a second etching paste 3b is printed on a part of silicon oxide film 9 provided on the back surface of silicon substrate 1, as shown in Fig. 2(h). Second etching paste 3b is printed by screen printing, for example, on the part of silicon oxide film 9 corresponding to the portion for forming the n⁺ layer. A paste having the same composition as the aforementioned first etching paste 3a containing phosphoric acid as the etching component can be employed as second etching paste 3b.

Thereafter a second heat treatment is performed on silicon substrate 1 printed with second etching paste 3b, thereby etching and removing the part of silicon oxide film 9, provided on the back surface of silicon substrate 1, printed with second etching paste 3b, as shown in Fig. 2(i). When the second diffusion mask is formed by a silicon oxide film, the heating temperature in the second heat treatment is preferably at least 300°C and not more than 400°C. There is such a tendency that etching is so insufficient that silicon oxide film 9 remains if the second diffusion mask is a silicon oxide film and the heating temperature for second etching paste 3b is less than 300°C, while there is a possibility that second etching paste 3b is scorched and stuck to the back surface of the silicon substrate and cannot be completely removed if the heating temperature exceeds 400°C. When the second diffusion mask is formed by a silicon nitride film, the heating temperature in the second heat treatment is preferably at least 200°C and not more than 400°C. There is such a tendency that etching is so insufficient that the silicon nitride film remains if the second diffusion mask is formed by a silicon nitride film and the heating temperature for second etching paste 3b is less than 200°C, while there is a possibility that second etching paste 3b is scorched and stuck to the back surface of the silicon substrate and cannot be completely removed if the heating temperature exceeds 400°C.

The treatment time in the second heat treatment is preferably at least 30 seconds and not more than 180 seconds. If the treatment time in the second heat treatment is less tan 30 seconds, there is a possibility that temperature distribution on the back surface of the silicon substrate is so dispersed as to cause dispersion in the etching rate when the heating temperature in the second heat treatment is set to 400°C. Even when the heating temperature exceeds 400°C, second etching paste 3b is so denatured that it is difficult to remove the same after the heating when long-time heating is performed, and hence the treatment time for second etching paste 3b is preferably in the range not exceeding 180 seconds.

After the second heat treatment, second etching paste 3b subjected to the second heat treatment is removed by dipping silicon substrate 1 in water, performing ultrasonic cleaning by applying ultrasonic waves and thereafter performing flowing water cleaning by feeding flowing water to the back surface of silicon substrate 1. Thus, it follows that the back surface of silicon substrate 1 is partially exposed. Also in this case, the back surface of silicon substrate 1 can also be cleaned by generally known RCA cleaning, cleaning with a mixed solution of sulfuric acid and hydrogen peroxide water or cleaning with a dilute aqueous hydrogen fluoride solution or a detergent containing a surface active agent, in addition to the flowing water cleaning.

Phosphorus which is an n-type impurity employed as a second conductivity type impurity is diffused in the exposed back surface of silicon substrate 1 by vapor phase diffusion employing POCl₃, whereby n⁺ layer 5 is formed as a second conductivity type impurity diffusion layer, as shown in Fig. 2(j). Thereafter silicon oxide films 9 provided on the photo-receiving surface and the back surface of silicon substrate 1 and PSG (phosphosilicate glass) formed by the diffusion of phosphorus are entirely removed with an aqueous hydrogen fluoride solution or the like, as shown in Fig. 2(k). Alternatively, n⁺ layer 5 may be formed by coating the exposed surface of the back surface of silicon substrate 1 with a solvent containing phosphorus and thereafter heating the same.

There is such a tendency that n⁺ layer 5 and p⁺ layer 6 come into contact with each other to cause a leakage current if the interval between n⁺ layer 5 and p⁺ layer 6 is too small while there is such a tendency that the characteristics are lowered if this interval is too large, and hence the interval between n⁺ layer 5 and p⁺ layer 6 is preferably at least 10 µm and not more than 200 µm, preferably at least 10 µm and not more than 100 µm, in view of improving the yield and the characteristics of the back junction solar cell.

Thereafter dry oxidation (thermal oxidation) is performed on silicon substrate 1, for forming silicon oxide film 9 on the back surface of silicon substrate 1 as a passivation film, as shown in Fig. 2(l). Then, antireflection film 7 consisting of a silicon nitride film is formed on the photo-receiving surface while contact holes are formed by partially removing silicon oxide film 9 thereby partially exposing n⁺ layer 5 and p⁺ layer 6, as shown in Fig. 2(m). The removal of silicon oxide film 9 can be performed by printing a third etching paste capable of etching silicon oxide film 9 on parts of the surface of silicon oxide film 9 provided on the back surface of silicon substrate 1 by screen printing or the like and thereafter performing a third heat treatment on silicon substrate 1 thereby removing the parts of silicon oxide film 9 printed with the third etching paste.

A paste of the same composition as the aforementioned first etching paste and/or the aforementioned second etching paste can be employed as the third etching paste, and the heating temperature and/or the treatment time for the third heat treatment can also be set to the same heating temperature and/or the same treatment time as the aforementioned first heat treatment and/or the aforementioned second heat treatment respectively.

After the third heat treatment, the third etching paste subjected to the third heat treatment is removed by dipping silicon substrate 1 in water, performing ultrasonic cleaning by applying ultrasonic waves and thereafter performing flowing water cleaning by feeding flowing water to the back surface of silicon substrate 1. Thus, it follows that the n⁺ layer 5 and p⁺ layer 6 are partially exposed. Also in this case, the back surface of silicon substrate 1 can also be cleaned by generally known RCA cleaning, cleaning with a mixed solution of sulfuric acid and hydrogen peroxide water or cleaning with a dilute aqueous hydrogen fluoride solution or a detergent containing a surface active agent, in addition to the flowing water cleaning.

Finally, a silver paste is printed on the respective ones of the exposed surface of n⁺ layer 5 and the exposed surface of p⁺ layer 6 and thereafter baked, thereby forming n electrode 12 on n⁺ layer 5 and forming p electrode 11 on p⁺ layer 6, as shown in Fig. 2(n). Thus, the back junction solar cell is completed.

The printing accuracy for etching pastes 3 and the silver paste can be improved by utilizing alignment marks 2 shown in Fig. 1(a).

Thus, according to the present invention, the manufacturing cost for the back junction solar cell can be remarkably reduced by substituting the printing steps for photolithographic steps.

### (Second Embodiment)

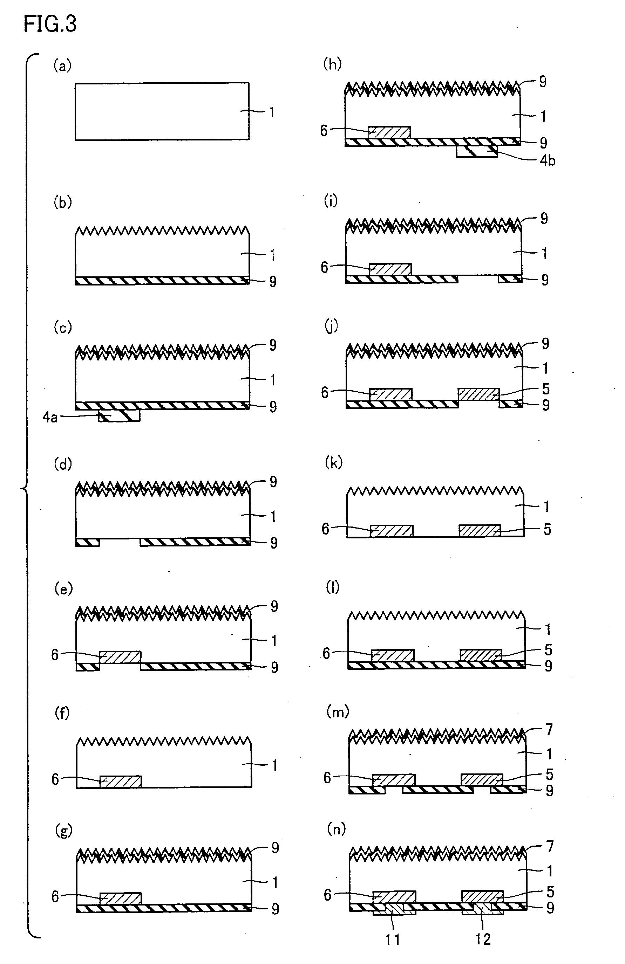

Figs. 3(a) to (n) are schematic sectional views showing other exemplary manufacturing steps in the method of manufacturing a back junction solar cell according to the present invention capable of obtaining the back junction solar cell shown in Figs. 1(a) and 1(b). This embodiment is characterized in that the etching components of etching pastes are different from those in the first embodiment. While only one n⁺ layer and only one p⁺ layer are formed on the back surface of a silicon substrate in each of Figs. 3(a) to (n) for convenience of illustration, a plurality of n⁺ layers and a plurality of p⁺ layers are formed in practice.

First, a silicon substrate 1 of the n-type which is a second conductivity type is prepared, as shown in Fig. 3(a). In order to improve printing accuracy of etching pastes, two circular alignment marks 2 are formed on the back surface of silicon substrate 1 with a laser marker, as shown in Fig. 1(a). Alignment marks 2 are preferably set on portions other than the portions for forming an n⁺ layer 5 and a p⁺ layer 6, in order not to reduce the performance of the back junction solar cell.

For example, a substrate from which slice damages resulting from slicing are removed or the like is employed as silicon substrate 1 shown in Fig. 3(a). The slice damages are removed from silicon substrate 1 by etching the surface of silicon substrate 1 with mixed acid of an aqueous hydrogen fluoride solution and nitric acid or an alkaline solution of sodium hydroxide or the like.

Then, a silicon oxide film 9 serving as a textured mask is formed on the back surface of silicon substrate 1, and a textured structure is further formed on the photo-receiving surface of silicon substrate 1, as shown in Fig. 3(b). Silicon oxide film 9 can be formed by steam oxidation, atmospheric pressure CVD or printing/baking of SOG (spin on glass), for example. Silicon oxide film 9, not particularly restricted in thickness, can be set to a thickness of at least 300 nm and not more than 800 nm, for example.

As the textured mask, a silicon nitride film or a laminate of a silicon oxide film and a silicon nitride film can be employed in place of the silicon oxide film. The silicon nitride film can be formed by plasma CVD or atmospheric pressure CVD, for example. The silicon nitride film, not particularly restricted in thickness, can be set to a thickness of at least 60 nm and not more than 100 nm, for example.

The silicon oxide film and/or the silicon nitride film forming the textured mask can be utilized also as a first diffusion mask in the subsequent impurity diffusing step. The silicon oxide film and/or the silicon nitride film forming the textured mask can also be temporarily removed after formation of the textured structure.

The textured structure of the photo-receiving surface can be formed by etching with a material obtained by heating a liquid prepared by adding isopropyl alcohol to an aqueous alkaline solution of sodium hydroxide or potassium hydroxide, for example, to at least 70°C and not more than 80°C, for example.

Then, silicon oxide film 9 provided on the back surface of silicon substrate 1 is temporarily removed with an aqueous hydrogen fluoride solution or the like, and silicon oxide films 9 serving as first diffusion masks are thereafter formed on the respective ones of the photo-receiving surface and the back surface of silicon substrate 1 again, as shown in Fig. 3(c). Then, a first etching paste 4a is printed on a part of silicon oxide film 9 provided on the back surface of silicon substrate 1. First etching paste 4a is printed by screen printing, for example, on the part of silicon oxide film 9 corresponding to the portion for forming the n⁺ layer.

First etching paste 4a contains at least one component selected from a group consisting of hydrogen fluoride, ammonium fluoride and ammonium hydrogen fluoride as the etching component, and further contains water, an organic solvent and a thickener as components other than the etching component. At least one of alcohol such as ethylene glycol, ether such as ethylene glycol monobutyl ether, ester such as propylene carbonate and ketone such as N-methyl-2-pyrrolidone can be employed as the organic solvent. While an organic solvent other than the above can also be employed, a solvent having a boiling point of about 200°C to hardly cause viscosity change of first etching paste 4a in printing is preferably selected in particular. At least one of cellulose, ethyl cellulose, a cellulose derivative, polyamide resin such as nylon 6 and a polymer such as polyvinyl pyrrolidone prepared by polymerizing a vinyl group can be employed as the thickener.

At least one component selected from the group consisting of hydrogen fluoride, ammonium fluoride and ammonium hydrogen fluoride employed as the etching component is preferably contained by at least 5 mass % and not more than 20 % with respect to the mass of overall first etching paste 4a. There is such a tendency that sufficient etching performance cannot be obtained if the content of at least one component selected from the group consisting of hydrogen fluoride, ammonium fluoride and ammonium hydrogen fluoride is less than 5 mass % with respect to the mass of the overall etching paste, and there is a possibility that the viscosity of first etching paste 4a so lowers as to cause a problem in printability if the content of at least one component selected from the group consisting of hydrogen fluoride, ammonium fluoride and ammonium hydrogen fluoride is larger than 20 mass % with respect to the mass of overall first etching paste 4a. If at least two of hydrogen fluoride, ammonium fluoride and ammonium hydrogen fluoride are contained, the total mass thereof is preferably at least 5 mass % and not more than 20 mass % with respect to the mass of overall etching paste 4a.

The viscosity of first etching paste 4a is preferably set to at least 10 Pa·s and not more than 25 Pa·s by properly selecting and adjusting the aforementioned materials, in order to attain compatibility between the etching property and the printability.

With this first etching paste 4a, etching progresses and the etching component is vaporized also under the room temperature, dissimilarly to the aforementioned first etching paste 3a. Therefore, etching progresses when the same is simply left at the room temperature, while the part not printed with first etching paste 4a is also etched by the vaporized etching component, and the first diffusion mask may be completely etched if the paste is left as it is. Therefore, heating of first etching paste 4a not only increases the etching rate but also functions to quickly vaporize the etching component and complete reaction thereby suppressing over-etching with the vaporized etching component. Thus, the thickness of the first diffusion mask described later, the heating temperature for a first heat treatment and the heat treatment time for the first heat treatment must be sufficiently studied, in order to etch the first diffusion mask while maintaining the performance of the first diffusion mask.

Silicon oxide film 9 serving as the first diffusion mask can be formed by steam oxidation, atmospheric pressure CVD or printing/baking of SOG (spin on glass), for example. Silicon oxide film 9, not particularly restricted in thickness, can be set to a thickness of at least 100 nm and not more than 300 nm, for example. As the first diffusion mask, a silicon nitride film or a laminate of a silicon oxide film and a silicon nitride film can be employed in place of the silicon oxide film. The silicon nitride film can be formed by plasma CVD or atmospheric pressure CVD, for example. The silicon nitride film, not particularly restricted in thickness, can be set to a thickness of at least 40 nm and not more than 80 nm, for example.

Then, the first heat treatment is performed on silicon substrate 1 printed with first etching paste 4a, thereby etching and removing the part of silicon oxide film 9, provided on the back surface of silicon substrate 1, printed with first etching paste 4a, as shown in Fig. 3(d). In this case, the heating temperature in the first heat treatment is preferably at least 50°C and not more than 200°C. There is such a tendency that it takes so long for completing etching that over-etching progresses if the first diffusion mask is formed by a silicon oxide film and the heating temperature for first etching paste 4a is less than 50°C, while there is a possibility that the etching component of first etching paste 4a is so abruptly vaporized that first etching paste 4a swells or forms bubbles to collapse the print pattern if the temperature exceeds 200°C.

The treatment time in the first heat treatment in this case is preferably at least 10 seconds and not more than 120 seconds. The aforementioned treatment time is preferably set to at least 10 seconds in order to completely vaporize the etching component of first etching paste 4a before completion of the first heat treatment thereby preventing progress of over-etching after the first heat treatment, when the heating temperature in the aforementioned first heat treatment is set to 200°C. When the heating temperature in the aforementioned first heat treatment is set to 50°C, there is such a tendency that the etching component of first etching paste 4a can be completely vaporized before completion of the first heat treatment by heating the same for 120 seconds.

As a result of experiments, the etching rate for heating first etching paste 4a printed on a silicon oxide film formed by atmospheric pressure CVD at 150°C was about 300 nm/min., and the etching rate for heating first etching paste 4a printed on a silicon nitride film at 150°C was about 150 nm/min.

The first heat treatment in this case is preferably performed by heating the substrate on a hot plate. This is because temperature distribution in silicon substrate 1 is not much increased by heating on the hot plate since the heating temperature in the first heat treatment may not be much increased and the apparatus may be corroded if a belt furnace or an oven is employed since the etching component is vaporized dissimilarly to the aforementioned first etching paste 3a. In the aforementioned experiments, the first heat treatment was performed by heating the substrate on a hot plate.

After the first heat treatment, first etching paste 4a subjected to the first heat treatment is removed by dipping silicon substrate 1 in water, performing ultrasonic cleaning by applying ultrasonic waves and thereafter performing flowing water cleaning by feeding flowing water to the back surface of silicon substrate 1. Thus, it follows that the back surface of silicon substrate 1 is partially exposed. Also in this case, the back surface of silicon substrate 1 can also be cleaned by generally known RCA cleaning, cleaning with a mixed solution of sulfuric acid and hydrogen peroxide water or cleaning with a dilute aqueous hydrogen fluoride solution or a detergent containing a surface active agent, in addition to the flowing water cleaning.

Boron which is a p-type impurity employed as a first conductivity type impurity is diffused in the exposed back surface of silicon substrate 1 by vapor phase diffusion employing BBr₃, whereby p⁺ layer 6 is formed as a first conductivity type impurity diffusion layer, as shown in Fig. 3(e). Thereafter silicon oxide films 9 provided on the photo-receiving surface and the back surface of silicon substrate 1 and BSG (borosilicate glass) formed by the diffusion of boron are entirely removed with an aqueous hydrogen fluoride solution or the like, as shown in Fig. 3(f). Alternatively, p⁺ layer 6 may be formed by coating the exposed surface of the back surface of silicon substrate 1 with a solvent containing boron and thereafter heating the same.

Then, silicon oxide films 9 are formed on the overall surfaces of the photo-receiving surface and the back surface of silicon substrate 1 as second diffusion masks, as shown in Fig. 3(g). Needless to say, silicon nitride films or laminates of silicon oxide films and silicon nitride films can be employed as the second diffusion masks, in place of the silicon oxide films.

Then, a second etching paste 4b is printed on a part of silicon oxide film 9 provided on the back surface of silicon substrate 1, as shown in Fig. 3(h). Second etching paste 4b is printed by screen printing, for example, on the part of silicon oxide film 9 corresponding to the portion for forming the n⁺ layer. A paste having the same composition as the aforementioned first etching paste 4a containing at least one component selected from the group consisting of hydrogen fluoride, ammonium fluoride and ammonium hydrogen fluoride as the etching component can be employed as second etching paste 4b.

Thereafter a second heat treatment is performed on silicon substrate 1 printed with second etching paste 4b, thereby etching and removing the part of silicon oxide film 9, provided on the back surface of silicon substrate 1, printed with second etching paste 4b, as shown in Fig. 3(i). In this case, the heating temperature in the second heat treatment is preferably at least 50°C and not more than 200°C. There is such a tendency that it takes so long for completing etching that over-etching progresses if the second diffusion mask is formed by a silicon oxide film and the heating temperature for second etching paste 4b is less than 50°C, while there is a possibility that the etching component of second etching paste 4b is so abruptly vaporized that second etching paste 4b swells or forms bubbles to collapse the print pattern if the temperature exceeds 200°C.

The treatment time in the second heat treatment in this case is preferably at least 10 seconds and not more than 120 seconds. The aforementioned treatment time is preferably set to at least 10 seconds in order to completely vaporize the etching component of first etching paste 4a before completion of the second heat treatment thereby preventing progress of over-etching after the second heat treatment, when the heating temperature in the aforementioned second heat treatment is set to 200°C. When the heating temperature in the aforementioned second heat treatment is set to 50°C, there is such a tendency that the etching component of second etching paste 4b can be completely vaporized before completion of the second heat treatment by heating the same for 120 seconds.

After the second heat treatment, second etching paste 4b subjected to the second heat treatment is removed by dipping silicon substrate 1 in water, performing ultrasonic cleaning by applying ultrasonic waves and thereafter performing flowing water cleaning by feeding flowing water to the back surface of silicon substrate 1. Thus, it follows that the back surface of silicon substrate 1 is partially exposed. Also in this case, the back surface of silicon substrate 1 can also be cleaned by generally known RCA cleaning, cleaning with a mixed solution of sulfuric acid and hydrogen peroxide water or cleaning with a dilute aqueous hydrogen fluoride solution or a detergent containing a surface active agent, in addition to the flowing water cleaning.

Phosphorus which is an n-type impurity employed as a second conductivity type impurity is diffused in the exposed back surface of silicon substrate 1 by vapor phase diffusion employing POCl₃, whereby n⁺ layer 5 is formed as a second conductivity type impurity diffusion layer, as shown in Fig. 3(j). Thereafter silicon oxide films 9 provided on the photo-receiving surface and the back surface of silicon substrate 1 and PSG (phosphosilicate glass) formed by the diffusion of phosphorus are entirely removed with an aqueous hydrogen fluoride solution or the like, as shown in Fig. 3(k). Alternatively, n⁺ layer 5 may be formed by coating the exposed surface of the back surface of silicon substrate 1 with a solvent containing phosphorus and thereafter heating the same.

There is such a tendency that n⁺ layer 5 and p⁺ layer 6 come into contact with each other to cause a leakage current if the interval between n⁺ layer 5 and p⁺ layer 6 is too small while there is such a tendency that the characteristics are lowered if this interval is too large, and hence the interval between n⁺ layer 5 and p⁺ layer 6 is preferably at least 10 µm and not more than 200 µm, preferably at least 10 µ and not more than 100 µm, in view of improving the yield and the characteristics of the back junction solar cell.

Thereafter dry oxidation (thermal oxidation) is performed on silicon substrate 1, for forming silicon oxide film 9 on the back surface of silicon substrate 1 as a passivation film, as shown in Fig. 3(l). Then, an antireflection film 7 consisting of a silicon nitride film is formed on the photo-receiving surface while contact holes are formed by partially removing silicon oxide film 9 thereby partially exposing n⁺ layer 5 and p⁺ layer 6, as shown in Fig. 3(m). The removal of silicon oxide film 9 can be performed by printing a third etching paste capable of etching silicon oxide film 9 on parts of the surface of silicon oxide film 9 provided on the back surface of silicon substrate 1 by screen printing or the like and thereafter performing a third heat treatment on silicon substrate 1 thereby removing the parts of silicon oxide film 9 printed with the third etching paste.

A paste of the same composition as the aforementioned first etching paste and/or the aforementioned second etching paste can be employed as the third etching paste, and the heating temperature and/or the treatment time for the third heat treatment can also be set to the same heating temperature and/or the same treatment time as the aforementioned first heat treatment and/or the aforementioned second heat treatment.

After the third heat treatment, the third etching paste subjected to the third heat treatment is removed by dipping silicon substrate 1 in water, performing ultrasonic cleaning by applying ultrasonic waves and thereafter performing flowing water cleaning by feeding flowing water to the back surface of silicon substrate 1. Thus, it follows that n⁺ layer 5 and p⁺ layer 6 are partially exposed. Also in this case, the back surface of silicon substrate 1 can also be cleaned by generally known RCA cleaning, cleaning with a mixed solution of sulfuric acid and hydrogen peroxide water or cleaning with a dilute aqueous hydrogen fluoride solution or a detergent containing a surface active agent, in addition to the flowing water cleaning.

Finally, a silver paste is printed on the respective ones of the exposed surface of n⁺ layer 5 and the exposed surface of p⁺ layer 6 and thereafter baked, thereby forming n electrode 12 on n⁺ layer 5 and forming p electrode 11 on p⁺ layer 6, as shown in Fig. 3(n). Thus, the back junction solar cell is completed.

The printing accuracy for the etching pastes and the silver paste can be improved by utilizing alignment marks 2 shown in Fig. 1 (a).

Thus, according to the present invention, the manufacturing cost for the back junction solar cell can be remarkably reduced by substituting the printing steps for photolithographic steps.

### Examples

### (Example 1)

First, an etching paste containing phosphoric acid as an etching component was prepared by mixing N-methyl-2-pyrrolidone, nylon 6 and an aqueous phosphoric acid solution (concentration of phosphoric acid: 85 mass %) with each other in mass ratios of N-methyl-2-pyrrolidone:nylon 6:aqueous phosphoric acid solution = 4:3:3 and sufficiently stirring the same. The viscosity of this etching paste was 25 Pa.s.

Then, a silicon substrate of the n-type which is a second conductivity type was prepared by slicing an n-type silicon single crystal into a square plate of 100 mm by 100 mm by 200 µm and removing slice damages by etching with mixed acid of an aqueous hydrogen fluoride solution and nitric acid.

Then, a silicon oxide film of 600 nm in thickness was formed on the back surface of the silicon substrate by atmospheric pressure CVD as a textured mask, and a photo-receiving surface of the silicon substrate was etched with an etching solution obtained by heating a liquid prepared by adding a small quantity of isopropyl alcohol to an aqueous sodium hydroxide solution to 80°C, thereby forming a textured structure on the photo-receiving surface of each silicon substrate.

Then, the silicon oxide film provided on the back surface of the silicon substrate was temporarily removed with an aqueous hydrogen fluoride solution or the like, and silicon oxide films of 150 nm in thickness were formed on the photo-receiving surface and the back surface of the silicon substrate as first diffusion masks. The etching paste prepared in the above was printed on a part of the silicon oxide film provided on the back surface of the silicon substrate by screen printing as a first etching paste.

Then, a first heat treatment was performed by heating the silicon substrate printed with the aforementioned first etching paste in a belt furnace at 300°C for 60 seconds, for etching the part of the silicon oxide film, provided on the back surface of the silicon substrate, printed with the first etching paste. After the first heat treatment, the first etching paste subjected to the first heat treatment was removed and the back surface of each silicon substrate was partially exposed from the etched part by dipping the silicon substrate in water, performing ultrasonic cleaning for 5 minutes by applying ultrasonic waves and thereafter performing flowing water cleaning by feeding flowing water to the back surface of the silicon substrate for 5 minutes.

Then, a p⁺ layer serving as a first conductivity type impurity layer was formed on the exposed part of the back surface of the silicon substrate by diffusing boron employed as a first conductivity type impurity in the exposed back surface of each silicon substrate by performing vapor phase diffusion employing BBr₃ under an atmosphere of 950°C for 60 minutes. Thereafter the silicon oxide films provided on the photo-receiving surface and the back surface of each silicon substrate and BSG (borosilicate glass) formed by the diffusion of boron were entirely removed with an aqueous hydrogen fluoride solution. A constant interval was provided between the p⁺ layer and the n⁺ layer formed on the back surface of the silicon substrate, and this interval was 50 µm.

Then, silicon oxide films of 150 nm in thickness were formed on the overall surfaces of the photo-receiving surface and the back surface of each silicon substrate as second diffusion masks. Then, a second etching paste of the same composition as the aforementioned first etching paste was printed on a part of the silicon oxide film provided on the back surface of each silicon substrate by screen printing.

Thereafter a second heat treatment was performed by heating the silicon substrate printed with the second etching paste in a belt furnace at the same heating temperature and for the same treatment time as the first heat treatment, for etching the part of the back surface of the silicon substrate printed with the first etching paste. After the second heat treatment, ultrasonic cleaning, flowing water cleaning and RCA cleaning were performed under the same conditions as the above, for partially exposing the back surface of the silicon substrate from the etched part.

Then, vapor phase diffusion employing POCl₃ was performed under an atmosphere of 900°C for 30 minutes, thereby diffusing phosphorus serving as a second conductivity type impurity in the exposed back surface of the silicon substrate and forming an n⁺ layer serving as a second conductivity type impurity diffusion layer on the exposed part of the back surface of the silicon substrate. Thereafter the silicon oxide films provided on the photo-receiving surface and the back surface of each silicon substrate and PSG (phosphosilicate glass) formed by the diffusion of phosphorus were entirely removed with an aqueous hydrogen fluoride solution.

Thereafter a silicon oxide film serving as a passivation film was formed on the back surface of the silicon substrate by dry oxidation, while a silicon nitride film was formed on the photo-receiving surface of the silicon substrate by plasma CVD as an antireflection film.

Then, a third etching paste of the same composition as the aforementioned first etching paste and the second etching paste was printed on a part of the silicon oxide film provided on the back surface of the silicon substrate by screen printing. Thereafter a third heat treatment was performed by heating the silicon substrate printed with the third etching paste in a belt furnace at the same heating temperature and for the same treatment time as the aforementioned first heat treatment and the second heat treatment, for etching the part of the silicon oxide film, provided on the back surface of the silicon substrate, printed with the third etching paste. After the third heat treatment, circular contact holes of about 100 µm in diameter were formed in the silicon oxide film provided on the back surface of the silicon substrate by performing ultrasonic cleaning and flowing water cleaning under the same conditions as the above, for exposing the n⁺ layer and the p⁺ layer respectively.

Finally, an n electrode serving as a second electrode was formed on the n⁺ layer and a p electrode serving as a first electrode was formed on the p⁺ layer by printing a silver paste on the respective ones of the exposed surface of the n⁺ layer and the exposed surface of the p⁺ layer and thereafter baking the same, thereby preparing a back junction solar cell according to Example 1.

Then, the characteristics of the back junction solar cell according to Example 1 were evaluated with a solar simulator. Table 1 shows the results. As comparison, Table 1 also shows results obtained by preparing a back junction solar cell according to comparative example 1 similarly to Example 1 except that the first etching paste, the second etching paste and the third etching paste were not employed but etching utilizing photolithographic steps was employed and that a p electrode and an n electrode were formed by vapor deposition through photolithographic steps and evaluating the characteristics of the back junction solar cell according to comparative example 1 similarly to Example 1.

As shown in Table 1, Jsc (short-circuit current density) of the back junction solar cell according to Example 1 was 38.8 mA/cm², Voc (open-circuit voltage) was 0.649 V, F.F. (fill factor) was 0.770, and Eff (conversion efficiency) was 19.40 %. These characteristics of the back junction solar cell according to Example 1 were substantially equivalent to the characteristics of the back junction solar cell according to comparative example 1.

### (Example 2)

First, an etching paste containing phosphoric acid as an etching component was prepared by mixing water, ethylene glycol monobutyl ether, ethyl cellulose and ammonium hydrogen fluoride with each other in mass ratios of water:ethylene glycol monobutyl ether:ethyl cellulose:ammonium hydrogen fluoride = 10:4:3:3 and sufficiently stirring the same. The viscosity of this etching paste was 15 Pa·s.

Then, a silicon substrate of the n-type which is a second conductivity type was prepared by slicing an n-type silicon single crystal into a square plate of 100 mm by 100 mm by 200 µm and removing slice damages by etching with mixed acid of an aqueous hydrogen fluoride solution and nitric acid.

Then, a silicon oxide film of 600 nm in thickness was formed on the back surface of the silicon substrate by atmospheric pressure CVD as a textured mask and a photo-receiving surface of the silicon substrate was etched with an etching solution obtained by heating a liquid prepared by adding a small quantity of isopropyl alcohol to an aqueous sodium hydroxide solution to 80°C, thereby forming a textured structure on the photo-receiving surface of each silicon substrate.

Then, the silicon oxide film provided on the back surface of the silicon substrate was temporarily removed with an aqueous hydrogen fluoride solution or the like, and silicon oxide films of 150 nm in thickness were formed on the photo-receiving surface and the back surface of the silicon substrate as first diffusion masks. The etching paste prepared in the above was printed on a part of the silicon oxide film provided on the back surface of the silicon substrate by screen printing as a first etching paste.

Then, a first heat treatment was performed by heating the silicon substrate printed with the aforementioned first etching paste on a hot plate at 150°C for 30 seconds, for etching the part of the silicon oxide film, provided on the back surface of the silicon substrate, printed with the first etching paste. After the first heat treatment, the first etching paste subjected to the first heat treatment was removed and the back surface of each silicon substrate was partially exposed from the etched part by dipping the silicon substrate in water, performing ultrasonic cleaning for 5 minutes by applying ultrasonic waves and thereafter performing flowing water cleaning by feeding flowing water to the back surface of the silicon substrate for 5 minutes.

Then, a p⁺ layer serving as a first conductivity type impurity layer was formed on the exposed part of the back surface of the silicon substrate by diffusing boron employed as a first conductivity type impurity in the exposed back surface of each silicon substrate by performing vapor phase diffusion employing BBr₃ under an atmosphere of 950°C for 60 minutes. Thereafter the silicon oxide films provided on the photo-receiving surface and the back surface of each silicon substrate and BSG (borosilicate glass) formed by the diffusion of boron were entirely removed with an aqueous hydrogen fluoride solution.

Then, silicon oxide films of 150 nm in thickness were formed on the overall surfaces of the photo-receiving surface and the back surface of each silicon substrate as second diffusion masks. Then, a second etching paste of the same composition as the aforementioned first etching paste was printed on a part of the silicon oxide film provided on the back surface of each silicon substrate by screen printing.

Thereafter a second heat treatment was performed by heating the silicon substrate printed with the second etching paste on a hot plate at the same heating temperature and for the same treatment time as the first heat treatment, for etching the part of the back surface of the silicon substrate printed with the second etching paste. After the second heat treatment, ultrasonic cleaning and flowing water cleaning were performed under the same conditions as the above, for partially exposing the back surface of the silicon substrate from the etched part.

Then, vapor phase diffusion employing POCl₃ was performed under an atmosphere of 900°C for 30 minutes, thereby diffusing phosphorus serving as a second conductivity type impurity in the exposed back surface of the silicon substrate and forming an n⁺ layer serving as a second conductivity type impurity diffusion layer on the exposed part of the back surface of the silicon substrate. Thereafter the silicon oxide films provided on the photo-receiving surface and the back surface of each silicon substrate and PSG (phosphosilicate glass) formed by the diffusion of phosphorus were entirely removed with an aqueous hydrogen fluoride solution. A constant interval was provided between the p⁺ layer and the n⁺ layer formed on the back surface of the silicon substrate, and this interval was 50 µm.

Thereafter a silicon oxide film serving as a passivation film was formed on the back surface of the silicon substrate by dry oxidation, while a silicon nitride film was formed on the photo-receiving surface of the silicon substrate by plasma CVD as an antireflection film.

Then, a third etching paste of the same composition as the aforementioned first etching paste and the second etching paste was printed on a part of the silicon oxide film provided on the back surface of the silicon substrate by screen printing. Thereafter a third heat treatment was performed by heating the silicon substrate printed with the third etching paste on a hot plate at the same heating temperature and for the same treatment time as the aforementioned first heat treatment and the second heat treatment, for etching the part of the silicon oxide film, provided on the back surface of the silicon substrate, printed with the third etching paste. After the third heat treatment, circular contact holes of about 100 µm in diameter were formed in the silicon oxide film provided on the back surface of the silicon substrate by performing ultrasonic cleaning and flowing water cleaning under the same conditions as the above, for exposing the n⁺ layer and the p⁺ layer respectively.

Finally, an n electrode serving as a first electrode was formed on the n⁺ layer and a p electrode serving as a second electrode was formed on the p⁺ layer by printing a silver paste on the respective ones of the exposed surface of the n⁺ layer and the exposed surface of the p⁺ layer and thereafter baking the same, thereby preparing a back junction solar cell according to Example 2.

Then, the characteristics of the back junction solar cell according to Example 2 were evaluated by the same method as and under the same conditions as Example 1. Table 1 shows the results.

As shown in Table 1, Jsc (short-circuit current density) of the back junction solar cell according to Example 2 was 37.9 mA/cm², Voc (open-circuit voltage) was 0.623 V, F.F. (fill factor) was 0.757, and Eff (conversion efficiency) was 17.85 %.

**[Table 1]**

| | Jsc (mA/cm²) | Voc (V) | F.F | Eff (%) |
|---|---|---|---|---|
| Example 1 | 38.8 | 0.649 | 0.770 | 19.40 |
| Example 2 | 37.9 | 0.623 | 0.757 | 17.85 |
| Comparative Example 1 | 38.2 | 0.654 | 0.778 | 19.43 |

While ammonium hydrogen fluoride was employed as the etching components of the etching pastes in the aforementioned Example 2, it has been also confirmed that characteristics similar to those of the aforementioned Example 2 are obtained whichever one of ammonium fluoride, hydrogen fluoride, a mixture of hydrogen fluoride and ammonium fluoride, a mixture of hydrogen fluoride and ammonium hydrogen fluoride, a mixture of ammonium fluoride and ammonium hydrogen fluoride and a mixture of hydrogen fluoride, ammonium fluoride and ammonium hydrogen fluoride is substituted for ammonium hydrogen fluoride.

The embodiments disclosed this time are mere examples in all points, and the present invention is not restricted to these. The present invention is shown not in the range described in the above but by the scope of claims for patent, and it is intended that all modifications within the meaning and range equivalent to the scope of claims for patent are included.

### INDUSTRIAL APPLICABILITY

According to the present invention, a method of manufacturing a back junction solar cell capable of reducing the manufacturing cost by substituting printing steps for photolithographic steps can be provided.

## Claims

1. A method of manufacturing a back junction solar cell having a p-n junction formed on the back surface of a first conductivity type or second conductivity type silicon substrate (1) opposite to the surface of the incident light side, comprising the steps of:
forming a first diffusion mask (9) on the back surface of said silicon substrate (1);
printing a first etching paste (3a, 4a) containing an etching component capable of etching said first diffusion mask (9) on a part of the surface of said first diffusion mask (9);
exposing a part of the back surface of said silicon substrate (1) by performing a first heat treatment on said silicon substrate (1) thereby removing the part of said first diffusion mask (9) printed with said first etching paste (3a, 4a);
forming a first conductivity type impurity diffusion layer (6) on the exposed back surface of said silicon substrate (1) by diffusing a first conductivity type impurity;
removing said first diffusion mask (9);
forming a second diffusion mask (9) on the back surface of said silicon substrate (1);
printing a second etching paste (3b, 4b) containing an etching component capable of etching said second diffusion mask (9) on a part of the surface of said second diffusion mask (9);
exposing another part of the back surface of said silicon substrate (1) by performing a second heat treatment on said silicon substrate (1) thereby removing the part of said second diffusion mask (9) printed with said second etching paste (3b, 4b);
forming a second conductivity type impurity diffusion layer (5) on the exposed back surface of said silicon substrate (1) by diffusing a second conductivity type impurity; and
removing said second diffusion mask (9).

2. The method of manufacturing a back junction solar cell according to claim 1, wherein
the etching component of at least either said first etching paste (3a, 4a) or said second etching paste (3b, 4b) is phosphoric acid.

3. The method of manufacturing a back junction solar cell according to claim 2, wherein
said etching component is contained by at least 10 mass % and not more than 40 mass % with respect to the mass of the overall etching paste.

4. The method of manufacturing a back junction solar cell according to claim 2, wherein
the viscosity of the etching paste containing said etching component is at least 10 Pa·s and not more than 40 Pa.s.

5. The method of manufacturing a back junction solar cell according to claim 2, wherein
the heating temperature for at least either said first heat treatment or said second heat treatment is at least 200°C and not more than 400°C.

6. The method of manufacturing a back junction solar cell according to claim 2, wherein
the treatment time for at least either said first heat treatment or said second heat treatment is at least 30 seconds and not more than 180 seconds.

7. The method of manufacturing a back junction solar cell according to claim 1, wherein
the etching component of at least either said first etching paste (3a, 4a) or said second etching paste (3b, 4b) is at least one component selected from a group consisting of hydrogen fluoride, ammonium fluoride and ammonium hydrogen fluoride.

8. The method of manufacturing a back junction solar cell according to claim 7, wherein
said etching component is contained
by at least 5 mass % and not more than 20 mass % with respect to the mass of the overall etching paste.

9. The method of manufacturing a back junction solar cell according to claim 7, wherein
the viscosity of the etching paste containing said etching component is at least 10 Pa·s and not more than 25 Pa·s.

10. The method of manufacturing a back junction solar cell according to claim 7, wherein
the heating temperature for at least either said first heat treatment or said second heat treatment is at least 50°C and not more than 200°C.

11. The method of manufacturing a back junction solar cell according to claim 7, wherein
the treatment time for at least either said first heat treatment or said second heat treatment is at least 10 seconds and not more than 120 seconds.

12. The method of manufacturing a back junction solar cell according to claim 1, wherein
said first conductivity type impurity diffusion layer (6) and said second conductivity type impurity diffusion layer (5) are not in contact with each other, but an interval of at least 10 µm and not more than 200 µm is provided between said first conductivity type impurity diffusion layer (6) and said second conductivity type impurity diffusion layer (5).

13. The method of manufacturing a back junction solar cell according to claim 1, wherein
at least either said first etching paste (3a, 4a) subjected to said first heat treatment or said second etching paste (3b, 4b) subjected to said second heat treatment is removed by ultrasonic cleaning and flowing water cleaning.

14. The method of manufacturing a back junction solar cell according to claim 1, wherein
at least either said first diffusion mask (9) or said second diffusion mask (9) is formed by at least either a silicon oxide film or a silicon nitride film.

15. The method of manufacturing a back junction solar cell according to claim 1, including the steps of:
forming a passivation film (9) on the back surface of said silicon substrate (1),
printing a third etching paste containing an etching component capable of etching said passivation film (9) on a part of the surface of said passivation film (9), and
exposing at least a part of said first conductivity type impurity diffusion layer (6) and at least a part of said second conductivity type impurity diffusion layer (5) by performing a third heat treatment on said silicon substrate (1) thereby removing the part of said passivation film (9) printed with said third etching paste,
after removing said second diffusion mask (9).

16. The method of manufacturing a back junction solar cell according to claim 15, wherein
the etching component of said third etching paste is at least one component selected from a group consisting of hydrogen fluoride, ammonium fluoride and ammonium hydrogen fluoride or phosphoric acid.

17. The method of manufacturing a back junction solar cell according to claim 15, including the step of forming a first electrode (11) in contact with the exposed surface of said first conductivity type diffusion layer (6) and a second electrode (12) in contact with the exposed surface of said second conductivity type impurity diffusion layer (5) respectively.
